# EUROPEAN PATENT APPLICATION

(11) **EP 4 726 415 A1**
(43) Date of publication of application: **15.04.2026**
(21) Application number: 24852199.9
(22) Date of filing: 01.08.2024
(51) Int. Cl.: G01R 31/392, G01R 31/385, G01R 31/389, G01R 19/10, G01R 19/165, G01R 19/00, G01R 31/371

(54) **BATTERY CELL INSPECTION DEVICE AND OPERATION METHOD THEREFOR**

(30) Priority: 04.08.2023 KR 20230102492
(71) Applicant: LG Energy Solution, Ltd., Seoul 07335 (KR)
(72) Inventor: CHO, In Hwan, Daejeon 34122 (KR); KIM, Ju Young, Daejeon 34122 (KR); LEE, Da Jin, Daejeon 34122 (KR); KANG, Ju Young, Daejeon 34122 (KR)
(74) Representative: Goddar, Heinz J.
(86) International application number: PCT/KR2024/011314
(87) International publication number: WO 2025/033845

(57) **Abstract**

A battery cell inspection apparatus according to an embodiment disclosed in this document may include a sensor configured to obtain an impedance value and at least two open-circuit voltage (OCV) values at different time points for each of a plurality of battery cells, and a processor configured to calculate a deviation (dOCV) between the OCV value at a first time point and the OCV value at a second time point, calculate a charge transfer resistance (R_{ct}) value for each of the battery cells based on the impedance value, classify the battery cells into a suspect group or a normal group based on the deviation, and detect defective battery cells among the suspect group based on the charge transfer resistance value.

## Description

### TECHNICAL FIELD

### CROSS REFERENCE TO RELATED APPLICATION

This application claims priority to Korean Patent Application No. 10-2023-0102492, filed August 04, 2023, the entire contents of which is incorporated herein for all purposes by this reference.

### Technical Field

The embodiments disclosed in this document relate to a battery cell inspection apparatus and operating method thereof.

### BACKGROUND ART

Recently, research and development on secondary batteries have been actively conducted. Here, the secondary battery is a rechargeable battery and includes all of the conventional Ni/Cd batteries, Ni/MH batteries, and recent lithium ion batteries. Among secondary batteries, lithium-ion batteries have the advantage of much higher energy density compared to traditional Ni/Cd and Ni/MH batteries. Moreover, with their compact and lightweight design, lithium-ion batteries serve as power sources for portable devices, and their recent extension to powering electric vehicles has attracted considerable attention as a next-generation energy storage solution.

Given the potential fire hazards associated with defective batteries, rigorous safety testing is imperative. Here, defective batteries may include those that experience more self-discharge than normal batteries due to issues such as separator defects or metallic foreign substances ingress during the manufacturing process.

Battery manufacturing incorporates an activation process to evaluate battery stability. The activation process involves activating the manufactured batteries and testing their safety. By pre-testing the safety of batteries through such an activation process, it is possible to prevent fires caused by defective batteries.

### DISCLOSURE

### TECHNICAL PROBLEM

The activation process can be broadly divided into the aging process and the charge/discharge process. The aging process involves storing the batteries under controlled temperature and humidity conditions to ensure uniform distribution of the electrolyte within the battery.

Typically, the aging and charge/discharge processes are repeated multiple times, and the battery's condition is assessed based on the obtained OCV values. However, the aging process is time-consuming, and detecting defective batteries through multiple aging cycles can take approximately 4 to 10 days.

The technical objects of the embodiments disclosed in this document are not limited to the aforesaid, and other objects not described herein with be clearly understood by those skilled in the art from the descriptions below.

### TECHNICAL SOLUTION

A battery cell inspection apparatus according to an embodiment disclosed in this document may include a sensor configured to obtain an impedance value and at least two open-circuit voltage (OCV) values at different time points for each of a plurality of battery cells, and a processor configured to calculate a deviation (dOCV) between the OCV value at a first time point and the OCV value at a second time point, calculate a charge transfer resistance (R_{ct}) value for each of the battery cells based on the impedance value, classify the battery cells into a suspect group or a normal group based on the deviation, and detect defective battery cells among the suspect group based on the charge transfer resistance value.

In an embodiment, the processor may classify the battery cells into the suspect group based on the deviation being equal to or greater than a first threshold value.

In an embodiment, the processor may calculate the average of the OCV values at the second time point for the normal group, for which the deviation is less than the first threshold value, calculate a first ratio between the OCV value at the second time point for each of the battery cells and the average, and detect the defective battery cells among the suspect group based on the first ratio.

In an embodiment, the processor may select the minimum charge transfer resistance value among the normal group as a reference value, calculate a second ratio between the charge transfer resistance value for each of the battery cells and the reference value, and detect the defective battery cells among the suspect group based on the first ratio and the second ratio.

In an embodiment, the processor may detect a battery cell as a defective battery cell based on the difference between the first ratio and the second ratio exceeding a second threshold value.

In an embodiment, the processor may detect a battery cell as an additional inspection target cell based on the deviation being less than the first threshold value and the difference between the first ratio and the second ratio being less than or equal to the second threshold value.

In an embodiment, the battery cell inspection apparatus may further include a communication circuit configured to transmit the detection results for the battery cells to a user terminal.

An operating method of a battery cell inspection apparatus according to an embodiment disclosed in this document may include obtaining an impedance value and at least two open-circuit voltage (OCV) values at different time points for each of a plurality of battery cells, calculating a deviation (dOCV) between the OCV value at a first time point and the OCV value at a second time point, calculating a charge transfer resistance (R_{ct}) value for each of the battery cells based on the impedance value, classifying the battery cells into a suspect group or a normal group based on the deviation, and detecting defective battery cells among the suspect group based on the charge transfer resistance value.

In an embodiment, the classifying of the battery cells may include classifying the battery cells into the suspect group based on the deviation being equal to or greater than a first threshold value.

In an embodiment, the operating method may further include calculating the average of the OCV values at the second time point for the normal group, for which the deviation is less than the first threshold value, and calculating a first ratio between the OCV value at the second time point for each of the battery cells and the average, wherein the detecting of defective battery cells among the suspect group may include detecting the defective battery cells among the suspect group based on the first ratio.

In an embodiment, the operating method may further include selecting the minimum charge transfer resistance value among the normal group as a reference value, and
calculating a second ratio between the charge transfer resistance value for each of the battery cells and the reference value, wherein the detecting of defective battery cells among the suspect group may include detecting the defective battery cells among the suspect group based on the first ratio and the second ratio.

In an embodiment, the detecting of defective battery cells among the suspect group may include detecting a battery cell as a defective battery cell based on the difference between the first ratio and the second ratio exceeding a second threshold value.

In an embodiment, the operating method may further include detecting a battery cell as an additional inspection target cell based on the deviation being less than the first threshold value and the difference between the first ratio and the second ratio being less than or equal to the second threshold value.

In an embodiment, the operating method may further include transmitting the detection results for the battery cells to a user terminal.

### ADVANTAGEOUS EFFECTS

The battery cell inspection device and operating method thereof disclosed in this document is advantageous in terms of reducing the cost and time required for safety testing of the batteries by diagnosing the condition of battery cells based on the OCV values obtained after two aging processes and the charge transfer resistance (R_{ct}).

The advantageous effects of the battery cell inspection apparatus and operating method thereof disclosed in this document are not limited to the aforesaid, and other effects not described herein with can be clearly understood by those skilled in the art from the descriptions below.

### DESCRIPTION OF DRAWINGS

FIG. 1 illustrates a battery cell manufacturing process system according to an embodiment disclosed in this document;
FIG. 2 is a block diagram of a battery cell inspection apparatus according to an embodiment disclosed in this document;
FIG. 3 illustrates a method for a battery cell inspection apparatus to classify battery cells into suspect and normal groups based on the dOCV values according to an embodiment disclosed in this document;
FIG. 4 illustrates a portion of the equivalent circuit of a battery cell according to an embodiment disclosed in this document;
FIG. 5 illustrates a method for a battery cell inspection apparatus to select a reference value among charge transfer resistance (R_{ct}) values of a normal group according to an embodiment disclosed in this document;
FIG. 6 illustrates a method for a battery cell inspection apparatus to detect defective battery cells among the suspect group based on the first and second ratios according to an embodiment disclosed in this document;
FIG. 7 is a flowchart illustrating a method for a battery cell inspection apparatus to classify battery cells into suspect and normal groups according to an embodiment disclosed in this document; and
FIG. 8 is a flowchart illustrating a method for a battery cell inspection apparatus to detect defective battery cells among the suspect group according to an embodiment disclosed in this document.

With regard to the explanation of the drawings, the same or similar reference numerals may be used for identical or similar components.

### MODE FOR INVENTION

Hereinafter, embodiments of the present invention are described with reference to accompanying drawings. However, the description is not intended to limit the present invention to particular embodiments, and it should be construed as including various modifications, equivalents, and/or alternatives of the embodiments described herein.

The embodiments and terms used in this document are not intended to limit the technical features disclosed in this document to specific embodiments, and should be understood to encompass various modifications, equivalents, or alternatives to the disclosed embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (such as importance or order), unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired or wirelessly) or indirectly (e.g., through a third component).

The methods according to various embodiments disclosed in this document can be included and provided in a computer program product. The computer program product may be traded between sellers and buyers as commodities. A computer program product can be distributed in the form of a device-readable storage medium (e.g., compact disc read-only memory, CD-ROM), or it can be distributed directly, online, between two user devices, or through an application store (e.g., download or upload). In the case of online distribution, at least part of the computer program product may be temporarily stored or temporarily created in a device-readable storage medium such as a manufacturer's server, an application store server, or a relay server's memory.

According to the embodiments disclosed in this document, each of the described components (e.g., modules or programs) may include one or more entities, and some of the plurality of entities may be separately arranged in other components. According to the embodiments disclosed in this document, one or more components or operations may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to the embodiments disclosed in this document, operations performed by modules, programs, or other components are executed sequentially, in parallel, iteratively, or heuristically, or one or more of the operations are executed in a different order, omitted, or one or more other operations may be added.

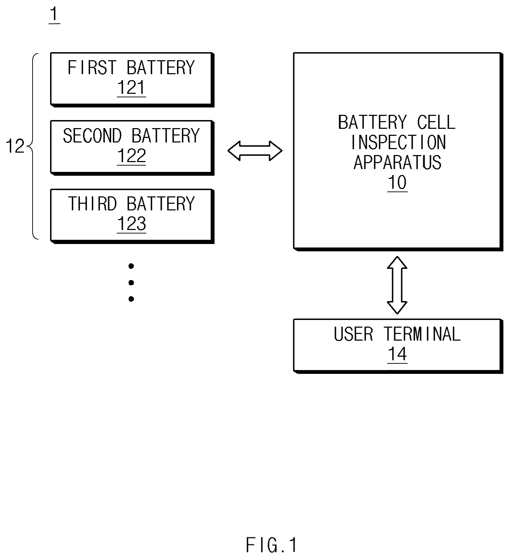

FIG. 1 illustrates a battery cell manufacturing process system 1 according to an embodiment disclosed in this document.

With reference to FIG. 1, the battery cell manufacturing process system 1 may include a battery cell inspection apparatus 10, a battery unit 12, a user terminal 14, or a combination thereof.

The battery unit 12 may include one or more batteries 121, 122, and 123. Here, each of the batteries 121, 122, and 123 may be a battery manufactured during the battery manufacturing process. Each of the batteries 121, 122, and 123 may be a battery cell, battery module, battery pack, or battery rack. The battery unit 12 may refer to a group of a predetermined number of batteries 121, 122, and 123 that are treated as a single unit for the purpose of battery manufacturing or safety testing. For example, the battery unit 12 may be a tray that contains a predetermined number of battery cells. A predetermined number of battery cells may be included in a single tray, and operations in the battery manufacturing process and activation process may be performed on a tray basis.

Hereinafter, it is assumed that each of the batteries 121, 122, and 123 is a battery cell. This is merely for the convenience of explanation, and each of the batteries 121, 122, and 123 is not limited to being a battery cell.

The battery cell inspection apparatus 10 may obtain the OCV values for each of the battery cells. The battery cell inspection apparatus 10 may acquire OCV values at least at two time points for each battery cell.

The battery cell inspection apparatus 10 may calculate the deviation (dOCV) between the OCV values at the two time points for each battery cell.

Based on whether the deviation between the OCV values at the two time points for each battery cell exceeds a first threshold value, the battery cell inspection apparatus 10 may classify the battery cells into suspect or normal groups. Here, the first threshold value may be a predetermined value based on the OCV values for each battery cell, degradation slope, and OCV reduction curve phenomenon.

The battery cell inspection apparatus 10 may calculate the average of the OCV values at the second point for the normal group.

The battery cell inspection apparatus 10 may also calculate a first ratio between the average of the OCV values at the second point for the normal group and the second point OCV values for each battery cell. Here, the first ratio may be obtained by dividing the second point OCV value of each battery cell by the average of the OCV values at the second point for the normal group.

The battery cell inspection apparatus 10 may calculate the charge transfer resistance values (R_{ct}) for each of the battery cells. The battery cell inspection apparatus 10 may calculate the charge transfer resistance values for each battery cell based on electrical impedance spectroscopy (EIS). The battery cell inspection apparatus 10 may derive the charge transfer resistance for the battery cells using the EIS device.

The battery cell inspection apparatus 10 may select the minimum charge transfer resistance value among the normal group as a reference value.

The battery cell inspection apparatus 10 may calculate a second ratio between the reference value and the charge transfer resistance values. Here, the second ratio may be obtained by dividing the charge transfer resistance value of each battery cell by the reference value.

The battery cell inspection apparatus 10 may detect defective battery cells based on the first and second ratios. The battery cell inspection apparatus 10 may also detect defective battery cells based on whether the difference between the first and second ratios exceeds a second threshold value. Here, the second threshold value may be a predetermined value set to eliminate the effects of voltage deviation on the charge transfer resistance values.

The battery cell inspection apparatus 10 may transmit the detection results to the user terminal 14. Here, the detection results may include classifications of each battery cell as a defective battery cell, normal battery cell, or additional inspection target cell.

In an embodiment, the battery cell inspection apparatus 10 may be connected to the battery unit 12 and the user terminal 14 via wired and/or wireless connections.

In an embodiment, the connection between the battery cell inspection apparatus 10 and the battery unit 12 may be a communication connection through a wired and/or wireless network. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network encompassing 4^{th} Generation (4G) and 5G network networks).

In an embodiment, the connection between the battery cell inspection apparatus 10 and the battery unit 12 may be a connection established through an inter-device communication interface (e.g., bus, general purpose input and output (GPIO), serial peripheral interface (SPI), or mobile industry processor interface (MIPI)).

In an embodiment, the connection between the battery cell inspection apparatus 10 and the user terminal 14 may be a communication link established through a wired and/or wireless network. In an embodiment, the battery cell inspection apparatus 10 may transmit the detection results to the user terminal 14. Here, the detection results may include the classifications of each battery cell as a defective battery cell, normal battery cell, or additional inspection target cell.

In an embodiment, the user terminal 14 may be a mobile device (e.g., portable phone, laptop computer, smartphone, and smart pad) or a personal computer (PC).

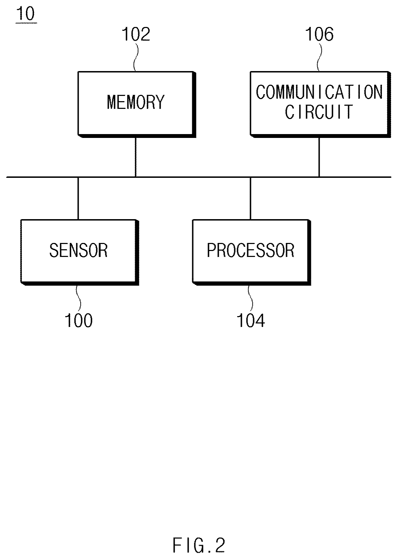

FIG. 2 is a block diagram of a battery cell inspection apparatus according to an embodiment disclosed in this document.

With reference to FIG. 2, the battery cell inspection apparatus 10 may include a sensor 100, a memory 102, a processor 104, a communication circuit 106, or a combination thereof. According to an embodiment, the battery cell inspection apparatus 10 shown in FIG. 2 may further include at least one additional component (e.g., a display, input device, or output device) other than the components illustrated in FIG. 2.

The sensor 100 may acquire values related to the state of the battery cells. In an embodiment, the values related to the state may include one or more values representing the voltage, current, resistance, state of charge (SOC), state of health (SOH), or temperature of the battery cells, or any combination thereof. In the following, a value related to a state may be referred to as a state value.

In an embodiment, the sensor 100 may obtain the open circuit voltage (OCV) values for each of the battery cells. The sensor 100 may acquire the OCV values of the battery cells at least at two time points.

In an embodiment, the sensor 100 may include an EIS device. The sensor 100 may obtain impedance values for each of the battery cells using the EIS device. Here, the EIS device may apply a sine waveform to the current or voltage of each battery cell and measure the changes in amplitude and phase in response to the applied signal, thereby obtaining frequency-specific impedance values.

According to another embodiment, when the operations performed by the battery cell inspection apparatus 10 are carried out by an external server or charger, the sensor 100 may not be included in the battery cell inspection apparatus 10.

The memory 102 may include volatile memory and/or nonvolatile memory.

In an embodiment, the memory 102 may store data used by at least one component of the battery cell inspection apparatus 10 (e.g., processor 104). For example, the data may include software (or related instructions), input data, or output data. In an embodiment, the instructions may be executed by the processor 104 for the battery cell inspection apparatus 10 to perform operations defined by the instructions. In an embodiment, the memory 102 may store one or more software programs.

The processor 104 may calculate the deviation (dOCV) between the OCV values at the two time points for each battery cell. The processor 104 may calculate the deviation between the OCV value at a first time point and the OCV value at a second time point for each of the battery cells. Here, the first time point may be earlier than the second time point.

The processor 104 may classify the battery cells into suspect or normal groups based on whether the calculated deviation is greater than or equal to a first threshold value. Here, the suspect group includes battery cells suspected to be defective, having a calculated deviation greater than or equal to the first threshold value. The normal group includes battery cells considered normal, having a calculated deviation less than the first threshold value.

The processor 104 may calculate the average of the OCV values of the normal group at the second time point. The processor 104 may calculate the average of the OCV values at the second time point for the battery cells included in the normal group.

The processor 104 may calculate the first ratio between the calculated average and the OCV value at the second time point for each battery cell. In an embodiment, the processor 104 may calculate the first ratio by dividing the OCV value at the second time point for each battery cell by the calculated average.

The processor 104 may calculate the charge transfer resistance value for each battery cell. The processor 104 may calculate the charge transfer resistance value for each battery cell based on the impedance values obtained by the sensor. The processor 104 may calculate the charge transfer resistance value for each battery cell based on the impedance values obtained by the EIS device.

The processor 104 may select the minimum charge transfer resistance value among the normal group as the reference value. The processor 104 may select the minimum charge transfer resistance value among the battery cells in the normal group as the reference value.

The processor 104 may calculate the second ratio between the charge transfer resistance value of each battery cell and the reference value. In an embodiment, the processor 104 may calculate the second ratio by dividing the charge transfer resistance value of each battery cell by the reference value.

The processor 104 may diagnose whether a battery cell is defective based on the first ratio and the second ratio. The processor 104 may detect defective battery cells among the suspect group based on the first ratio and the second ratio. The processor 104 may detect defective battery cells among the suspect group based on whether the difference between the first ratio and the second ratio exceeds a second threshold value.

The processor 104 may detect defective battery cells among the suspect group based on the difference between the first ratio and the second ratio. The processor 104 may diagnose a battery cell as a defective battery cell when the difference between the first ratio and the second ratio exceeds a second threshold value. The processor 104 may detect defective battery cells among the suspect group when the difference between the first ratio and the second ratio exceeds a second threshold value.

The processor 104 may detect additional inspection target cells among the suspect group based on the first ratio and the second ratio. The processor 104 may diagnose a battery cell as an additional inspection target cell when the difference between the first ratio and the second ratio is less than or equal to the second threshold value. The processor 104 may diagnose a battery cell as an additional inspection target cell when the deviation exceeds a first threshold value and the difference between the first ratio and the second ratio is less than or equal to a second threshold value. Here, additional inspection may refer to measuring additional OCV for the additional inspection target cells and then re-performing the operations conducted by the aforementioned battery cell inspection apparatus.

In an embodiment, the processor 104 may include a central processing unit, an application processor, a graphic processing unit, a neural processing unit (NPU), an image signal processor, a sensor hub processor, or a communication processor.

In an embodiment, the processor 104 may execute software stored to control at least one other component (e.g., hardware or software component) of the battery cell inspection apparatus 10 connected to the processor 104 and perform various data processing or computations.

The communication circuit 106 may establish wired communication channels and/or wireless communication channels between the battery cell inspection apparatus 10 and the battery unit 12 and/or the user terminal 14, and may exchange data with the battery unit 12 and/or the user terminal 14 through the established communication channels.

In an embodiment, the communication circuit 106 may transmit the detection results for the battery cells to the user terminal 14. The communication circuit 106 may transmit the detection results for the battery cells to the user terminal 14 through the established wired and/or wireless communication channels. The communication circuit 106 may transmit the detection results for defective battery cells among the battery cells to the user terminal 14. The communication circuit 106 may transmit the detection results for the additional inspection target cells among the battery cells to the user terminal 14. The communication circuit 106 may transmit the detection results for the normal battery cells among the battery cells to the user terminal 14.

In an embodiment, the battery cell inspection apparatus 10 may be included in a battery management system (BMS) capable of diagnosing the battery cells, and the operations performed by the battery cell inspection apparatus 10 may be carried out by the BMS.

In another embodiment, the battery cell inspection apparatus 10 may be included in a server or charger capable of diagnosing the battery cells, and the operations performed by the battery cell inspection apparatus 10 may be carried out by the server or charger.

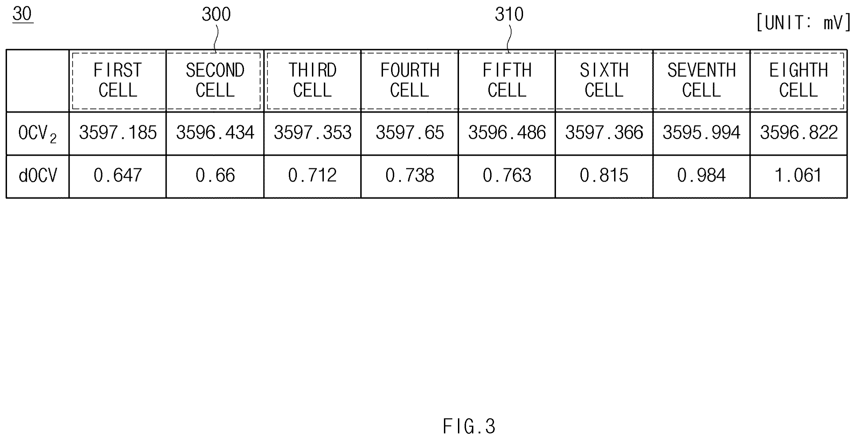

FIG. 3 illustrates a method for a battery cell inspection apparatus 10 to classify battery cells into suspect and normal groups based on the dOCV values according to an embodiment disclosed in this document.

FIG. 3 shows an OCV table 30 with the OCV values at the second time point (OCV₂) for eight battery cells, along with the deviations (dOCV) between the OCV values at the first time point (OCV₁) and OCV₂.

With reference to OCV table 30, the sensor 100 may obtain the OCV values for the first to third cells.

The processor 104 may calculate the deviation (dOCV) between the OCV value at the first time point (OCV₁) and the OCV value at the second time point (OCV₂) for each of the first to eighth cells.

The processor 104 may classify the battery cells into suspect or normal groups based on whether the calculated deviation (dOCV) exceeds the first threshold value. For example, the first threshold value may be 0.7 mV. The processor 104 may classify the third to eighth cells 310 with a dOCV of 0.7 mV or higher as suspect group. The processor 104 may classify the first and second cells 300 with a dOCV of less than 0.7 mV as normal group.

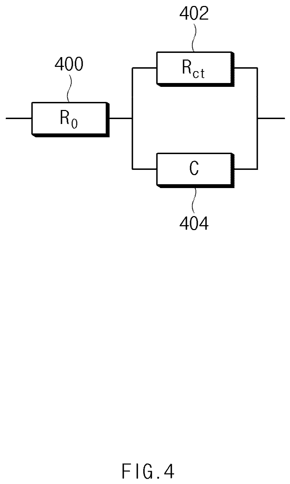

FIG. 4 illustrates a portion of the equivalent circuit of a battery cell according to an embodiment disclosed in this document.

With reference to FIG. 4, the equivalent circuit of the battery cell may include a series resistor (R_{O}) 400 and an RC ladder 402 and 404. The RC ladder 402 and 404 may include a charge transfer resistor (R_{ct}) 402 and a capacitor (C) 404.

The sensor 100 may obtain the impedance value for the battery cell based on electrochemical spectroscopy. The sensor 100 may use the EIS device to acquire the impedance value for the battery cell. Here, the impedance value may include the values of the series resistor 400, charge transfer resistor 402, and capacitor 404.

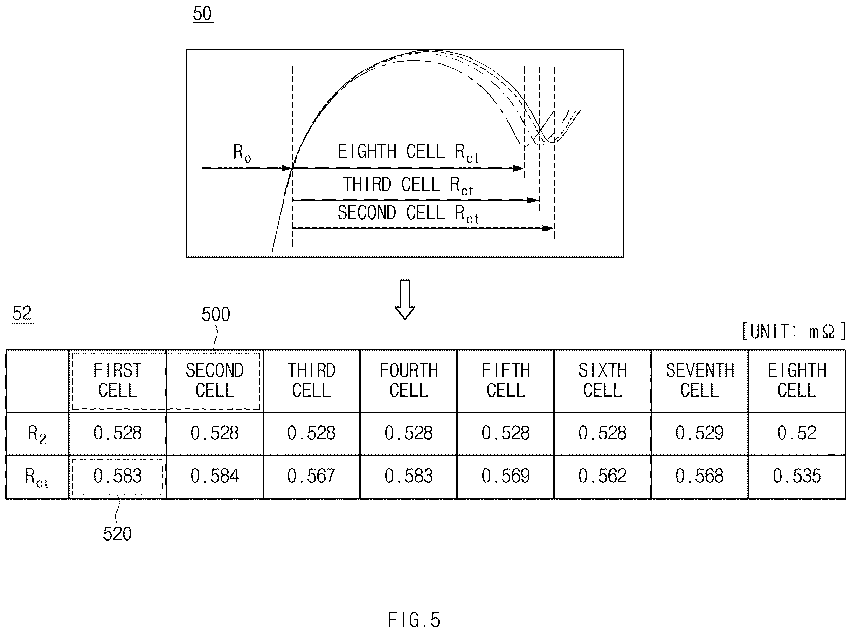

FIG. 5 illustrates a method for a battery cell inspection apparatus 10 to select a reference value among charge transfer resistance (R_{ct}) values of a normal group according to an embodiment disclosed in this document;

FIG. 5 shows a table 52 with calculated resistance values of the series resistance 400 and charge transfer resistor 402 for the battery cells based on the impedance table 50 obtained by the sensor 100.

With reference to the table 52 with the calculated resistance values, the processor 104 may select a charge transfer resistance value that meets specified conditions among the charge transfer resistance values of the first cell and second cell 500 classified as the normal group as the reference value. In an embodiment, the processor 104 may select the charge transfer resistance value 520 of the first cell, which is the minimum charge transfer resistance value among the charge transfer resistance values of the first cell and second cell 500 classified as the normal group, as the reference value.

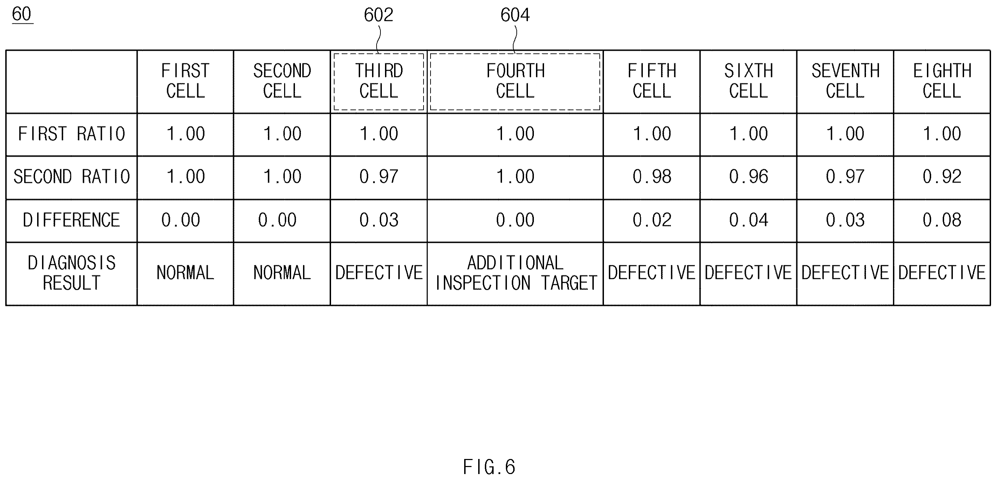

FIG. 6 illustrates a method for a battery cell inspection apparatus 10 to detect defective battery cells among the suspect group based on the first and second ratios according to an embodiment disclosed in this document.

FIG. 6 shows a table 60 used to determine the defectiveness of the battery cells based on the first ratio and second ratio for the first cell to the eighth cell.

With reference to the table 60, the processor 104 may calculate the average of the OCV values at the second time point for the normal group. The processor 104 may calculate the average of the OCV values at the second time point for the first cell and second cell 500.

The processor 104 may calculate the first ratio between the calculated average and the OCV value at the second time point for each battery cell. The processor 104 may calculate the first ratio between the calculated average and the OCV2 of each of the first cell to the eighth cell. The processor 104 may calculate the first ratio by dividing the OCV₂ of each of the first cell to the eighth cell by the calculated average.

The processor 104 may calculate the second ratio between the charge transfer resistance value of each battery cell and the reference value. The processor 104 may calculate the second ratio by dividing the charge transfer resistance values of each of the first cell to the eighth cell by the reference value 520.

The processor 104 may diagnose whether a battery cell is defective based on the first ratio and the second ratio. The processor 104 may detect defective battery cells among the suspect group based on whether the difference between the first ratio and the second ratio exceeds a second threshold value. For example, the second threshold value may be 0.01. The processor 104 may diagnose the third cell 602 as a defective battery cell when the difference between the first ratio and the second ratio exceeds 0.01.

The processor 104 may detect the fourth cell 604 as an additional inspection target cell when the difference between the first ratio and the second ratio is 0.01 or less among the suspect group.

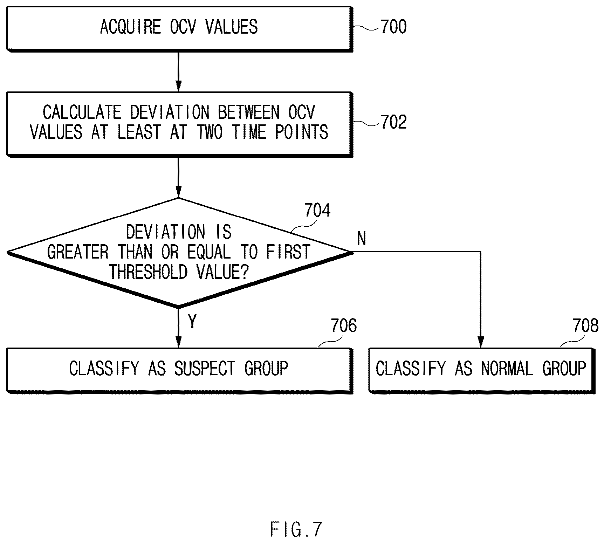

FIG. 7 is a flowchart illustrating a method for a battery cell inspection apparatus 10 to classify battery cells into suspect and normal groups according to an embodiment disclosed in this document.

With reference to FIG. 7, in operation 700, the sensor 100 may acquire the OCV values for each of the battery cells. The sensor 100 may acquire the OCV values of the battery cells at least at two time points. In an embodiment, the sensor 100 may include an EIS device. The sensor 100 may obtain impedance values for each of the battery cells using the EIS device.

In operation 702, the processor 104 may calculate the deviation (dOCV) between the OCV values at the two time points for each battery cell. The processor 104 may calculate the deviation between the OCV value at a first time point and the OCV value at a second time point for each of the battery cells.

In operation 704, the processor 104 may determine whether the calculated deviation is greater than or equal to the first threshold value. The processor 104 may determine whether the deviation between the calculated OCV values for each of the battery cells is greater than or equal to the first threshold value. The processor 104 may classify the battery cells into suspect or normal groups based on whether the deviation between the calculated OCV values for each of the battery cells is greater than or equal to the first threshold value.

In operation 706, the processor 104 may classify the battery cells with deviations between the calculated OCV values that are greater than or equal to the first threshold value as suspect group.

In operation 708, the processor 104 may classify the battery cells with deviations between the calculated OCV values that are less than the first threshold value as normal group.

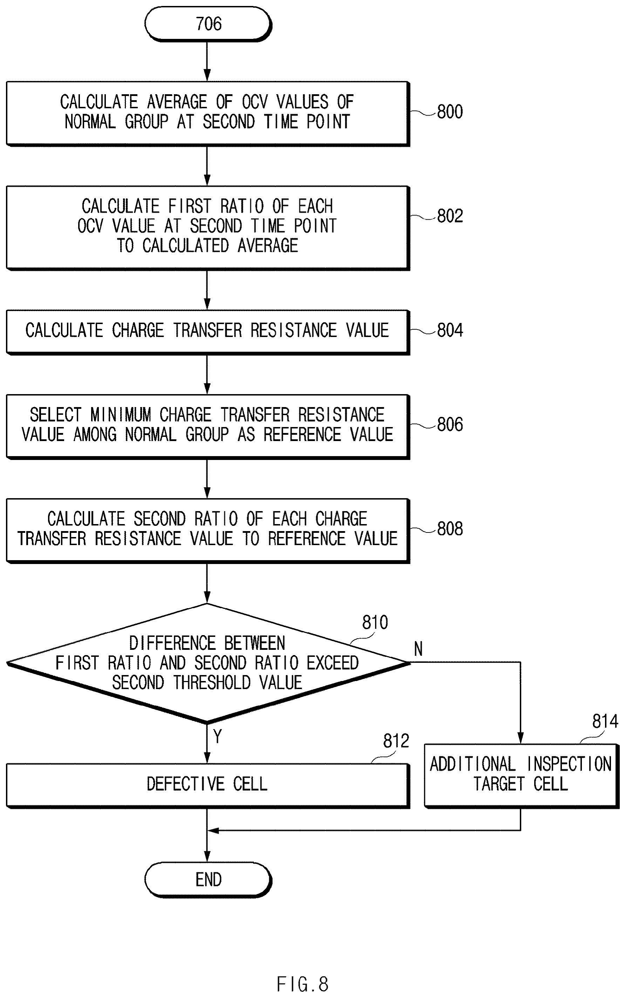

FIG. 8 is a flowchart illustrating a method for a battery cell inspection apparatus 10 to detect defective battery cells among the suspect group according to an embodiment disclosed in this document.

FIG. 8 is a flowchart illustrating a method for the battery cell inspection apparatus 10 to detect defective battery cells among the suspect group classified in operation 706.

In operation 800, the processor 104 may calculate the average of the OCV values of the normal group at the second time point. The processor 104 may calculate the average of the OCV values at the second time point for the battery cells included in the normal group.

In operation 802, the processor 104 may calculate the first ratio between the calculated average and the OCV value at the second time point for each battery cell. In an embodiment, the processor 104 may calculate the first ratio by dividing the OCV value at the second time point for each battery cell by the calculated average.

In operation 804, the processor 104 may calculate the charge transfer resistance value for each battery cell. The processor 104 may calculate the charge transfer resistance value for each battery cell based on the impedance values obtained by the sensor. The processor 104 may calculate the charge transfer resistance value for each battery cell based on the impedance values obtained by the EIS device.

In operation 806, the processor 104 may select the minimum charge transfer resistance value among the normal group as the reference value. The processor 104 may select the minimum charge transfer resistance value among the battery cells in the normal group as the reference value.

In operation 808, the processor 104 may calculate the second ratio between the charge transfer resistance value of each battery cell and the reference value. In an embodiment, the processor 104 may calculate the second ratio by dividing the charge transfer resistance value of each battery cell by the reference value.

In operation 810, the processor 104 may diagnose whether a battery cell is defective based on the first ratio and the second ratio. The processor 104 may detect defective battery cells among the suspect group based on the first ratio and the second ratio. The processor 104 may detect defective battery cells among the suspect group based on whether the difference between the first ratio and the second ratio exceeds a second threshold value.

In operation 812, the processor 104 may detect defective battery cells among the suspect group based on the difference between the first ratio and the second ratio. The processor 104 may diagnose a battery cell as a defective battery cell when the difference between the first ratio and the second ratio exceeds a second threshold value. The processor 104 may detect defective battery cells among the suspect group when the difference between the first ratio and the second ratio exceeds a second threshold value. Optionally, the communication circuit 106 may transmit the detection results obtained by the processor 104 to the user terminal 14.

In operation 814, the processor 104 may detect additional inspection target cells among the suspect group based on the first ratio and the second ratio. Among the suspect group, the processor 104 may diagnose a battery cell as an additional inspection target cell when the difference between the first ratio and the second ratio is less than or equal to the second threshold value. The processor 104 may detect a battery cell as an additional inspection target cell when the deviation exceeds a first threshold value and the difference between the first ratio and the second ratio is less than or equal to a second threshold value. Optionally, the communication circuit 106 may transmit the detection results obtained by the processor 104 to the user terminal 14.

Also, the terms such as "comprise", "include", or "have" used above implies that the corresponding component may be present unless otherwise stated specifically, and thus it should be construed as being able to further include other components rather than exclude other components. Unless otherwise defined, all terms, including technical or scientific terms used herein, have the same meanings as commonly understood by those skilled in the art to which the embodiments disclosed in this invention belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

The above description is only an illustrative example of the technical idea disclosed in this document, and those skilled in the art to which the embodiments disclosed in this document belong will be able to make various modification and changes without departing from the subject matter of the embodiments disclosed in this document. Therefore, the embodiments disclosed in this document are not intended to limit the technical concept disclosed in this document but are for the purpose of illustration, and the scope of the technical concept disclosed in this document is not limited by these embodiments. The scope of protection for the technical concepts disclosed in this document should be interpreted in accordance with the claims set forth below, and all equivalent technical concepts should be considered as included in the scope of protection of this document.

## Claims

1. A battery cell inspection apparatus comprising:
a sensor configured to obtain an impedance value and at least two open-circuit voltage (OCV) values at different time points for each of a plurality of battery cells; and
a processor configured to calculate a deviation (dOCV) between the OCV value at a first time point and the OCV value at a second time point, calculate a charge transfer resistance (R_{ct}) value for each of the battery cells based on the impedance value, classify the battery cells into a suspect group or a normal group based on the deviation, and detect defective battery cells among the suspect group based on the charge transfer resistance value.

2. The battery cell inspection apparatus of claim 1, wherein the processor classifies the battery cells into the suspect group based on the deviation being equal to or greater than a first threshold value.

3. The battery cell inspection apparatus of claim 2, wherein the processor calculates the average of the OCV values at the second time point for the normal group, for which the deviation is less than the first threshold value, calculates a first ratio between the OCV value at the second time point for each of the battery cells and the average, and detects the defective battery cells among the suspect group based on the first ratio.

4. The battery cell inspection apparatus of claim 3, wherein the processor selects the minimum charge transfer resistance value among the normal group as a reference value, calculates a second ratio between the charge transfer resistance value for each of the battery cells and the reference value, and detects the defective battery cells among the suspect group based on the first ratio and the second ratio.

5. The battery cell inspection apparatus of claim 4, wherein the processor detects a battery cell as a defective battery cell based on the difference between the first ratio and the second ratio exceeding a second threshold value.

6. The battery cell inspection apparatus of claim 5, wherein the processor detects a battery cell as an additional inspection target cell based on the deviation being less than the first threshold value and the difference between the first ratio and the second ratio being less than or equal to the second threshold value.

7. The battery cell inspection apparatus of claim 1, further comprising a communication circuit configured to transmit the detection results for the battery cells to a user terminal.

8. An operating method of a battery cell inspection apparatus, the method comprising:
obtaining an impedance value and at least two open-circuit voltage (OCV) values at different time points for each of a plurality of battery cells;
calculating a deviation (dOCV) between the OCV value at a first time point and the OCV value at a second time point;
calculating a charge transfer resistance (R_{ct}) value for each of the battery cells based on the impedance value;
classifying the battery cells into a suspect group or a normal group based on the deviation; and
detecting defective battery cells among the suspect group based on the charge transfer resistance value.

9. The method of claim 8, wherein the classifying of the battery cells comprises classifying the battery cells into the suspect group based on the deviation being equal to or greater than a first threshold value.

10. The method of claim 9, further comprising:
calculating the average of the OCV values at the second time point for the normal group, for which the deviation is less than the first threshold value; and
calculating a first ratio between the OCV value at the second time point for each of the battery cells and the average,
wherein the detecting of defective battery cells among the suspect group comprises detecting the defective battery cells among the suspect group based on the first ratio.

11. The method of claim 10, further comprising:
selecting the minimum charge transfer resistance value among the normal group as a reference value; and
calculating a second ratio between the charge transfer resistance value for each of the battery cells and the reference value,
wherein the detecting of defective battery cells among the suspect group comprises detecting the defective battery cells among the suspect group based on the first ratio and the second ratio.

12. The method of claim 11, wherein the detecting of defective battery cells among the suspect group comprises detecting a battery cell as a defective battery cell based on the difference between the first ratio and the second ratio exceeding a second threshold value.

13. The method of claim 12, further comprising detecting a battery cell as an additional inspection target cell based on the deviation being less than the first threshold value and the difference between the first ratio and the second ratio being less than or equal to the second threshold value.

14. The method of claim 8, further comprising transmitting the detection results for the battery cells to a user terminal.
